(19) **Europäisches Patentamt**
**European Patent Office**
**Office européen des brevets**

(11) **EP 1 085 792 B1**

(12) **EUROPÄISCHE PATENTSCHRIFT**

(45) Veröffentlichungstag und Bekanntmachung des Hinweises auf die Patenterteilung:
**31.12.2008 Patentblatt 2009/01**

(51) Int Cl.:
***H05K 3/40*** *(2006.01)*

(21) Anmeldenummer: **00118351.6**

(22) Anmeldetag: **24.08.2000**

(54) **Verfahren zum Herstellen einer Leiterplatte sowie Leiterplatte**

Process for manufacturing a circuit board, and circuit board

Procédé de fabrication d'un panneau à circuit, et panneau à circuit

(84) Benannte Vertragsstaaten:
**DE FR GB**

(30) Priorität: **15.09.1999 DE 19944102**
**24.09.1999 DE 19945794**

(43) Veröffentlichungstag der Anmeldung:
**21.03.2001 Patentblatt 2001/12**

(73) Patentinhaber: **Curamik Electronics GmbH**
**92676 Eschenbach (DE)**

(72) Erfinder:
• **Schulz-Harder, Jürgen Dr.Ing**
**91207 Lauf (DE)**

• **Meyer, Andreas**
**92676 Eschenbach (DE)**

(74) Vertreter: **Graf, Helmut et al**
**Patentanwälte**
**Graf Wasmeier Glück**
**Postfach 10 08 26**
**93008 Regensburg (DE)**

(56) Entgegenhaltungen:
**EP-A- 0 627 875      DE-A- 19 608 683**
**DE-U- 1 920 061      US-A- 4 319 708**
**US-H- H 650**

**Beschreibung**

Die Erfindung bezieht sich auf ein Verfahren zum Herstellen einer Leiterplatte (auch Substrat) und dabei spezieller auf ein Verfahren gemäß Oberbegriff Patentanspruch 1 oder 2 sowie auf eine Leiterplatte (auch Substrat) gemäß Oberbegriff Patentanspruch 5 oder 6.

Bekannt ist es, die zum Herstellen von Leiterbahnen, Anschlüssen usw. benötigte Metallisierung auf einer Keramik, z.B. auf einer Aluminium-Oxid-Keramik mit Hilfe der sogenannten Direct-Bonding-Technology und bei Metallisierungen aus Kupfer mit der des sogenannten "DCB-Verfahrens" (Direct-Copper-Bonding-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug aus einer chemischen Verbindung aus dem Metall und einem reaktiven Gas, bevorzugt Sauerstoff aufweisen.

Bei diesem beispielsweise in der US-PS 37 44 120 oder in der DE-PS 23 19 854 beschriebenen Verfahren bildet diese Schicht oder dieser Überzug aus der chemischen Verbindung aus dem Metall und einem reaktiven Gas (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:

- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1065 bis 1083°C, z.B. auf ca. 1071 °C;
- Abkühlen auf Raumtemperatur.

Bekannt ist weiterhin auch ein sogenanntes Aktiv-Lötverfahren (auch Diffusions-Lötverfahren) zum Verbinden von Metall mit Keramiken aus Carbiden (DE 2 213 115). Bei diesem bekannten Verfahren wird zwischen dem Metall und der Keramik ein Aktiv-Lot verwendet, d.h. ein Lot mit einem Aktiv-Metall, dessen Bindungsenthalpie zur Keramik wenigstens 50% der Bindungsenthalpie der betreffenden Keramik beträgt, so dass beim Erhitzen auf 800 bis 1000° C nicht nur eine Verbindung des Lotes mit der Metallisierung erreicht wird, sondern das im Lot enthaltene Aktiv-Metall auch Bindungsbrücken mit dem Carbid bzw. mit der Keramik bildet.

Bekannt ist weiterhin ein Verfahren zum Herstellen von Leiterplatten mit Durchkontaktierungen (US 4 319 708), bei dem ausgehend von einem Substrat, welches aus einer Trägerschicht aus einem elektrisch isolierenden Material, nämlich aus einem polymeren Material und aus auf die Oberflächenseiten dieser Trägerschicht aufgebrachten Metallschichten besteht, beide Metallschichten im Bereich der in der Trägerschicht vorgesehenen Öffnung in diese Öffnung hineinverformt und miteinander verbunden werden, so dass im Bereich der Öffnung eine Durchkontaktierung erhalten wird. Die Verbindung der bleibend verformten Metallisierungen innerhalb der Öffnung erfolgt durch "Kaltschweißen" bzw. durch eine metallurgische Verbindung unter Anwendung eines hohen Verformungs- oder Pressdrucks.

Bekannt ist weiterhin ein Verfahren zum Herstellen von Leiterplatten (DE-U-19 20 061), bei dem zur Erzeugung von Durchkontaktierungen die auf die beiden Oberflächenseiten der Trägerplatte aufkaschierten Metallfolien im Bereich einer Öffnung in diese Öffnung hinein mit Hilfe zweier Stempel verformt und innerhalb der Öffnung durch die zugleich als Schweißelektroden dienenden Stempel durch Elektroschweißen (Widerstandsschweißen) miteinander verbunden werden. Die Metallisierungen sind auf die Oberflächenseiten der elektrisch isolierenden Trägerplatte aufkaschiert oder chemisch aufgetragen.

Bekannt ist speziell auch ein Verfahren zum Herstellen eines Substrates (EP 0 627 875), bei dem zur Erzeugung einer Durchkontaktierung, d.h. eine elektrische Verbindung zwischen einer oberen und einer unteren Metallisierung innerhalb des Umfangs des Substrates in eine Öffnung der Isolierschicht ein Metallkörper eingelegt wird, der dann anschließend durch Pressen auf die Dicke der Isolierschicht verformt wird. Im Anschluss daran erfolgt zum Vervollständigen der Durchkontaktierung das elektrische Verbinden bzw. Bonden zwischen dem eingesetzten Metallkörper und den von Metallfolien oder Metallschichten gebildeten Metallisierungen, und zwar beispielsweise mit Hilfe des DCB-Prozesses.

Nachteilig bei diesem bekannten Verfahren ist, dass das Bonden bei hoher Prozesstemperatur erfolgt und der Metallkörper einer wesentlich größeren thermischen Ausdehnung unterliegt als die Isolierschicht, so dass beim Bonden die Metallisierungen am Rand der jeweiligen Öffnung von der Isolierschicht abheben und somit auch nach Herstellung des Substrates die Metallisierungen in der unmittelbaren Umgebung der Durchkontaktierungen nicht vollständig mit den Oberflächenseiten der Isolierschicht bzw. Keramikschicht verbunden sind.

Aufgabe der Erfindung ist es, ein Verfahren aufzuzeigen, mit dem die Herstellung von Leiterplatten bestehend aus einer Trägerschicht aus Keramik mit Durchkontaktierungen unter Vermeidung der Nachteile des vorstehend genannten Standes der Technik, d.h. mit verbesserter thermischer Stabilität möglich ist. Zur Lösung dieser Aufgabe ist ein Verfahren entsprechend dem Patentanspruch 1 oder 2 ausgebildet. Eine Leiterplatte ist Gegenstand des Patentanspruchs 5 oder 6.

Hinsichtlich der Ausbildung des erfindungsgemäßen Verfahrens bzw. der erfindungsgemäßen Leiterplatte bestehen verschiedenste Möglichkeiten, so beispielsweise:

- Das Verformen der einen Metallisierung erfolgt durch einen Stempel, wobei z.B. wenigstens eine Metallisierung im Bereich der Öffnung hohlniet- oder tüllen- oder napfartig verformt wird oder ist.

- Das elektrische Verbinden erfolgt bevorzugt durch Elektroschweißen oder aber durch Ultraschall- und/oder Laserschweißen und/oder mit Hilfe eines Direct-Bonding-Prozesses oder eines Aktiv-Lötverfahrens und/oder unter Verwendung eines Lots, vorzugsweise unter Verwendung einer Lötpaste, und/oder unter Verwendung einer Leitpaste, vorzugsweise einer aushärtbaren Leitpaste, wobei beispielsweise das Elektroschweißen beim oder unmittelbar nach dem Verformen der wenigstens einen Metallisierung, vorzugsweise durch das beim Verformen verwendete Werkzeug, und/oder das Direct-Bonding beispielsweise durch Erhitzen in einer $N_2/O_2$ - Atmosphäre mit einem $O_2$-Gehalt von 5-800ppm auf DCB-ProzessTemperatur erfolgen bzw. erfolgt sind.

- Die Schicht aus dem Dielektrikum besitzt beispielsweise eine Dicke im Bereich zwischen ca. 0,15 bis 2mm und/ oder die Metallisierungen sind Metallfolien, z.B. Kupferfolien, deren Dicke $d_{cu}$ etwa dem 0,2 bis 1,0 - Fachen der Dicke der Isolierschicht entspricht. Die Öffnung für die wenigstens eine Durchkontaktierung besitzen beispielsweise einen Durchmesser, der etwa 0,9 - 10 der Dicke ($d_c$) der Isolierschicht ist.

Weiterbildungen des Verfahrens sind Gegenstand der Unteransprüche. Die Erfindung wird im folgenden anhand der Figuren an Ausführungsbeispielen näher erläutert. Es zeigen:

Fig. 1 in verschiedenen Positionen die Verfahrensschritte eines Verfahrens zum Herstellen einer Leiterplatte oder eines Substrates mit einer Durchkontaktierung;

Fig. 2 in verschiedenen Positionen Verfahrensschritte bei dem Verfahren der Figur 1 zum elektrischen Verbinden bei der Herstellung der Durchkontaktierung;

Fig. 3 in Darstellungen ähnlich Figur 1 eine weitere, mögliche Ausführungsform des Verfahrens;

Fig. 4 verschiedene Verfahrensschritte bei einer weiteren Ausführungsform des erfindungsgemäßen Verfahrens;

Fig. 5 die Verfahrensschritte bei einem Verfahren ähnlich der Figur 4.

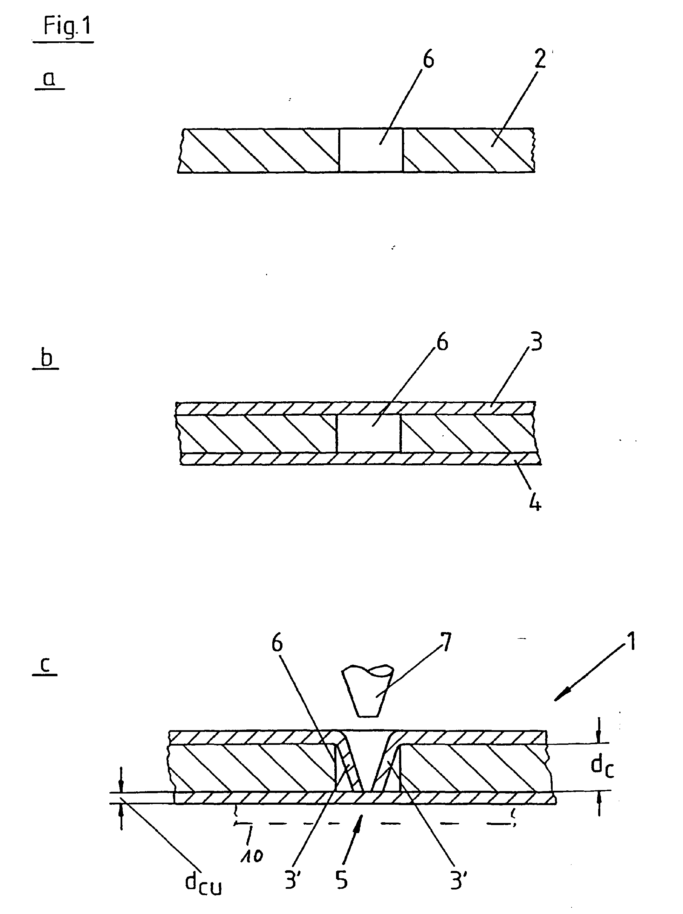

Die Figur 1 zeigt in Position c in Teildarstellung und im Schnitt eine Leiterplatte bzw. ein Substrat 1, welches für elektrische Schaltkreise oder Schaltungen bestimmt ist und im wesentlichen aus einer Platte oder Schicht 2 aus einem Dielektrikum bzw. isolierenden Material, beispielsweise aus Keramik oder einem anderen geeigneten isolierenden Material, beispielsweise aus Leiterplattenmaterial besteht und an ihrer Oberseite mit einer Metallisierung 3 und an der Unterseite mit einer Metallisierung 4 versehen ist. Beide Metallisierungen 3 und 4 sind jeweils flächig mit der Schicht 2 verbunden. Wenigstens eine der Metallisierungen 3 und 4 ist zur Bildung von Leiterbahnen, Kontaktflächen, Anschlüssen usw. strukturiert, und zwar beispielsweise unter Verwendung bekannter Techniken, wie z.B. Maskierungs- und Ätztechniken.

Das Substrat 1 besitzt wenigstens eine Durchkontaktierung 5, d.h. einen Bereich, an dem die obere Metallisierung 3 mit der unteren Metallisierung 4 elektrisch verbunden ist, und zwar innerhalb des Umfangs des Substrates 1. Die Herstellung des Substrates 1 mit der Durchkontaktierung 5 erfolgt entsprechend den in der Figur 1 dargestellten Verfahrensschritten. Zunächst wird die Schicht 2 aus dem Dielektrikum mit einer durchgehenden Öffnung 6 zur Verfügung gestellt. Im Anschluß daran werden auf beide Oberflächenseiten der Schicht 2 die Metallisierungen 3 und 4 als Metallfolien, vorzugsweise als Kupferfolien aufgebracht und mittels bekannter Techniken, beispielsweise mit Hilfe des Direct-Bonding-Verfahrens oder des Aktiv-Löt-Verfahrens flächig mit den Oberflächenseiten der Schicht 2 verbunden, sofern diese aus Keramik besteht (beispielsweise aus Aluminiumoxid oder Aluminiumnitrid).

Nach dem Aufbringen der Metallisierungen 3 und 4 ist die Öffnung 6 von beiden Metallisierungen abgedeckt. In einem weiteren Verfahrensschritt erfolgt dann mit Hilfe eines geeigneten Werkzeuges bzw. Stempels 7 eine bleibende Verformung der Metallisierung 3 in ihrem die Öffnung 6 abdeckenden Bereich derart, daß diese Metallisierung einen in die Öffnung 6 hineingezogenen, bis an die Metallisierung 4 reichenden, durchstoßenen, durchgezogenen bzw. tüllenartigen Abschnitt 3' bildet, der dann in einem weiteren Verfahrensschritt zum Vervollständigen der Durchkontaktierung elektrisch mit der Metallisierung 4 verbunden wird.

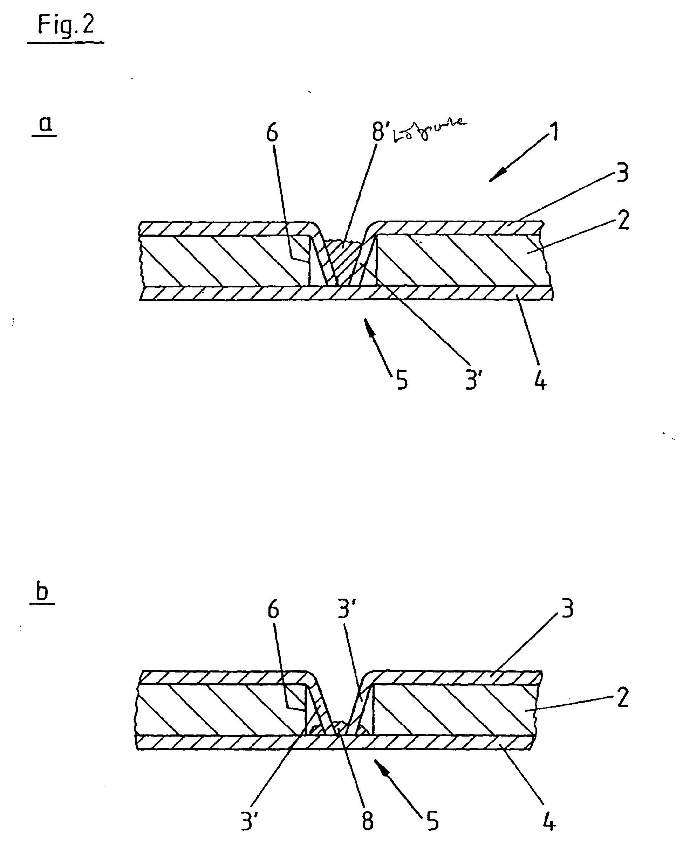

Die Figur 2 zeigt in verschiedenen Verfahrensschritten eine Möglichkeit für die Herstellung dieser elektrischen Verbindung. Hierbei wird nach dem Erzeugen des durchgezogenen, tüllenartigen Abschnitts 3' in die dann an der Oberseite des Substrates 1 freiliegende und in der Metallisierung 3 gebildete Öffnung ein Lot, beispielsweise in Form von Lötpaste 8' eingebracht und das Substrat 1 anschließend auf eine Löttemperatur erhitzt, so daß dann über das Lot 8 eine elektrische Verbindung zwischen dem Abschnitt 3' und damit zwischen der Metallisierung 3 und der Metallisierung 4 in Form der Durchkontaktierung 5 erzeugt ist. Auch andere Verfahren zum Herstellen der elektrischen Verbindung sind denkbar, beispielsweise unter Verwendung von elektrischem Strom (Elektroschweißen), durch eine nochmalige Anwendung des DCB-Prozesses, bei dem dann der untere Rand des nach innen gezogenen Abschnittes 3' eine direkte Verbindung mit der in der Öffnung 6 freiliegenden Fläche der Metallisierung 4 eingeht. Weiterhin kann die elektrische Verbindung auch unter Verwendung von unter Hitzeeinwirkung aushärtenden Leitpasten oder Leitklebern hergestellt werden. Der DCB-Prozeß zum Herstellen der elektrischen Verbindung zwischen dem Abschnitt 3' und der Metallisierung 4 erfolgt beispielsweise in einer $N_2/O_2$ Atmosphäre mit einem $O_2$ Gehalt von 5-800ppm.

Die Dicke $d_c$ der Schicht 2 liegt beispielsweise in der Größenordnung von 0,15-2mm. Die Dicke $d_{cu}$ der Metallisierungen 3 und 4 beträgt beispielsweise 0,2 - 1,0 der Dicke der Schicht 2. Der Durchmesser der Öffnung 6 beträgt etwa 0,9 - 10 der Dicke der Schicht 2.

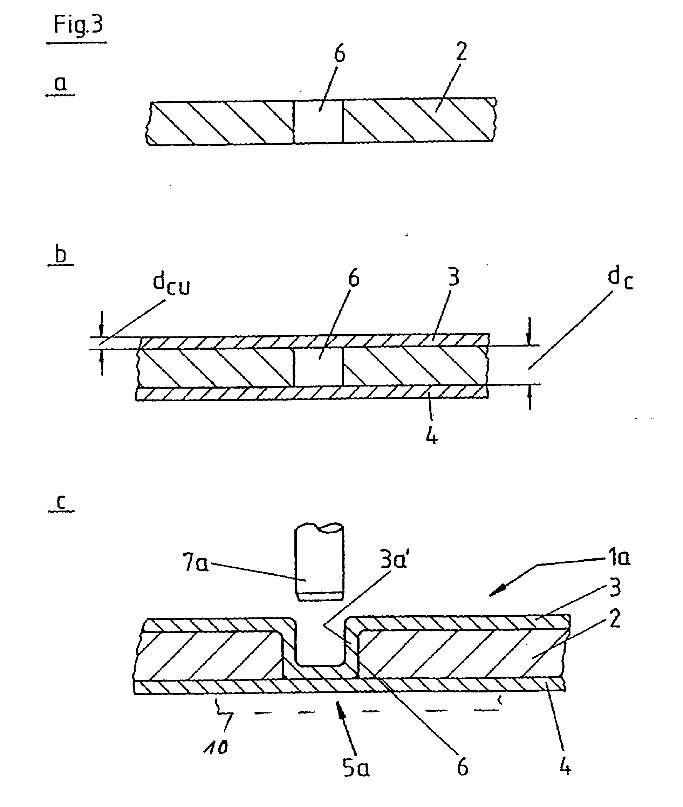

Die Figur 3 zeigt in verschiedenen Darstellungen ähnlich denen der Figur 1 als weitere Möglichkeit die Herstellung eines Substrates 1a mit einer Durchkontaktierung 5a. Bei diesem Verfahren wird nach dem Aufbringen der Metallisierungen 3 und 4 mittels eines geeigneten Werkzeuges 7a das Material der Metallisierung 3 im Bereich der Öffnung 6 bleibend napfartig in diese Öffnung 6 verformt, und zwar derart, daß der napfartig verformte Bereich oder Abschnitt 3a' mit der Unterseite seines Napfbodens die in der Öffnung 6 freiliegende Metallisierung 4 berührt. Zum Vervollständigen der Durchkontaktierung 5a erfolgt eine elektrische Verbindung zwischen dem Abschnitt 3' und der Metallisierung 4. Dies ist wiederum auf verschiedenste Weise möglich, beispielsweise dadurch, daß der zum Formen des napfartigen Abschnittes 3a verwendete Stempel 7a als Elektrode für eine Schweißverbindung ausgebildet ist. Auch andere Methoden sind möglich, beispielsweise punktförmiges Laserschweißen, Anwendung des DCB-Prozesses usw..

Bei der in den Figuren 1 - 3 dargestellten Ausführungsform wird für die Herstellung der Durchkontaktierung 5 bzw. 5a jeweils nur eine Metallisierung, d. h. die obere Metallisierung 3 bleibend verformt, während die untere Metallisierung 4 nicht verformt wird. Hierfür stützt sich die untere Metallisierung 4 an ihrer der Isolierschicht 2 abgewandten Seite an einer flächigen Anlage 10, beispielsweise an einer Anlagefläche des Werkzeugs ab, welches auch den Stempel 7 bzw. 7a aufweist.

Diese Verformung nur der oberen Metallisierung 3 hat den entscheidenden Vorteil, daß ein einfaches Werkzeug verwendet werden kann und daß insbesondere für die Isolierschicht 2, die vorzugsweise eine Keramikschicht ist, eine übermäßige Belastung durch Biegen vermieden ist, da sich das Substrat beim Verformen der Metallisierung 3 flächig mit der Metallisierung 4 an der Anlage 10 abgestützt. Ein ganz wesentlicher Vorteil besteht aber darin, daß durch die Verformung nur der Metallisierung 3 bei der weiteren Verwendung des Substrates die Metallisierung 4 auf ihrer gesamten Fläche für eine Strukturierung zur Bildung von Leiterbahnen, Kontaktflächen usw. zur Verfügung steht. Diese Strukturierung kann dann mit den dem Fachmann bekannten Techniken (z. B. Maskieren und Ätzen) erfolgen. Die Metallisierung 4 bildet dann die Oberseite eines derartigen strukturierten Substrates und die Metallisierung 3 die Unterseite. Leiterbahnen, Kontaktflächen usw. können also auch unmittelbar an einer Durchkontaktierung 5 bzw. 5a vorgesehen werden, so daß eine dichte und raumsparende Bestückung des Substrates mit Bauelementen möglich ist.

Sind die Metallisierungen 3 und 4 durch Anwendung der DCB-Technik oder des Aktiv-Lötverfahrens auf die Oberflächenseiten der Isolierschicht 2 aufgebracht, also mit Verfahren, die bei relativ hohen Temperaturen durchgeführt werden, so hat dies den weiteren Vorteil, daß durch diese hohen Temperaturen das Kupfermaterial der Kupferfolien oder Kupferschichten sich in einem Zustand (weichgeglühten Zustand) befindet, in dem das bleibende Verformen des Materials der Metallisierung 3 mit dem Stempel 7 bzw. 7a besonders zuverlässig mit der erforderlichen Tiefe möglich ist.

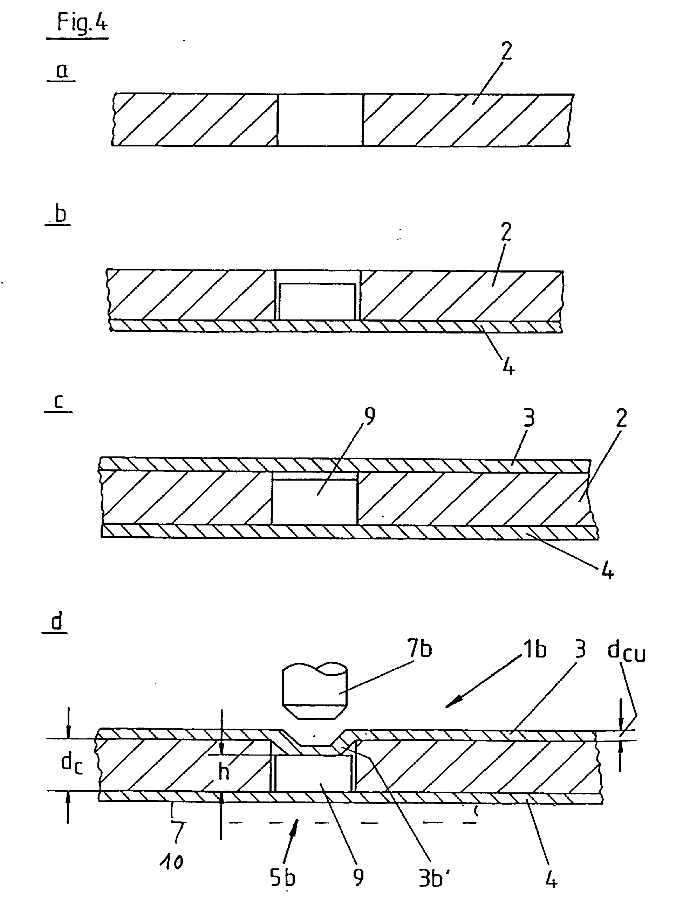

Die Figur 4 zeigt als weitere Möglichkeit die Herstellung eines Substrates 1b bei dem die Durchkontaktierung 5b von einem Körper 9 gebildet ist, der in die Öffnung 6 eingesetzt und mit den Metallisierungen 3 und 4 elektrisch verbunden ist. Die Herstellung des Substrates 1b erfolgt also in der Weise, daß auf die mit der Öffnung 6 versehene Schicht zunächst eine der beiden Metallisierungen, beispielsweise die Metallisierung 4 flächig aufgebracht wird, Im Anschluß daran wird in die Öffnung 6 der Metallkörper 9 eingesetzt, der beispielsweise als Kugel, Kubus, Quader, Zylinder, Rombus usw. geformt ist und dessen Abmessungen so gewählt sind, daß der Metallkörper 9 nach dem Einsetzen in der Öffnung 6 vollständig aufgenommen ist, d.h. die Höhe des eingesetzten Metallkörpers 9 kleiner ist als die Dicke dc der Schicht 2.

In einem weiteren Verfahrensschritt wird dann die weitere Metallisierung 3 auf die Oberseite der Schicht 2 flächig aufgebracht, beispielsweise wiederum in Form einer Metallfolie z.B. unter Verwendung des DCB-Verfahrens oder eines Aktiv-Lötverfahrens. In einem weiteren Verfahrensschritt wird dann eine der beiden Metallisierungen, beispielsweise die Metallisierung 3 unter Verwendung eines Stempels oder Werkzeugs 7b im Bereich der Öffnung 6 derart bleibend napfartig in die Öffnung 6 hinein verformt, daß der Metallkörper 9 in physikalischen Kontakt sowohl mit der Metallisierung 3 als auch mit der Metallisierung 4 ist. Die Durchkontaktierung 5b wird wiederum dadurch vervollständigt, daß beide Metallisierungen mit dem Metallkörper 9 elektrisch verbunden werden. Dies ist beispielsweise dadurch möglich, daß das Werkzeug 7b zugleich als Schweißelektrode ausgebildet ist, also beim Verformen auch die elektrische Verbindung zwischen dem Metallkörper 9 und den Metallisierungen 3 und 4 erfolgt. Grundsätzlich bestehen aber auch andere Möglichkeiten für die elektrische Verbindung, beispielsweise unter Anwendung des DCB-Verfahrens oder durch andere Bonding-Prozesse. Der Metallkörper 9 ist vorzugsweise ein solcher aus Kupfer.

Wie vorstehend ausgeführt wurde, sind die Abmessungen des Metallkörpers 9 so gewählt, daß dessen Höhe h, mit der der Metallkörper nach dem Einsetzen in die Öffnung 6 senkrecht zu den Ebenen der Metallisierungen 3 und 4 orientiert ist, kleiner ist als die Dicke $d_c$ die Schicht 2. Die Höhe h ist vorzugsweise entsprechend der nachstehenden Formel gewählt:

$$h \leq d_c \left[ (1 + (\alpha_1 - \alpha_2) \Delta T \right] + K$$

hierbei sind:

$\alpha_1$ thermischer Ausdehnungskoeffizient des Materials Schicht 2,

$\alpha_2$ thermischer Ausdehnungskoeffizient des Materials des Metallkörpers 9,

$\Delta T$ Temperaturdifferenz zwischen der bei der elektrischen Verbindung der Metallschichten 3 und 4 mit dem Körper 9 verwendeten maximalen Prozeßtemperatur und der Raumtemperatur. K ist hierbei eine Konstante bzw. ein Korrekturwert- oder faktor, der bei Anwendung des Direct Bonding Prozesses bzw. des DCB-Prozesses der doppelten Schichtstärke der jeweiligen bei diesem Prozeß auftretenden eutektischen Aufschmelzzone entspricht. Bei den üblichen DCB-Verfahren beträgt dieser Korrekturwert etwa 5 - 50 $\mu$m.

Wird die Höhe h entsprechend der vorstehenden Bedingung gewählt, so ist gewährleistet, daß selbst bei höheren, für die elektrische Verbindung bzw. für das Bonden erforderlichen Prozeßtemperaturen, beispielsweise beim DCB-Bonden, die Metallisierungen 3 und 4 auch im Bereich des Randes der Öffnungen 6 vollständig mit dem betreffenden Oberflächenseiten der Schicht 2 verbunden sind.

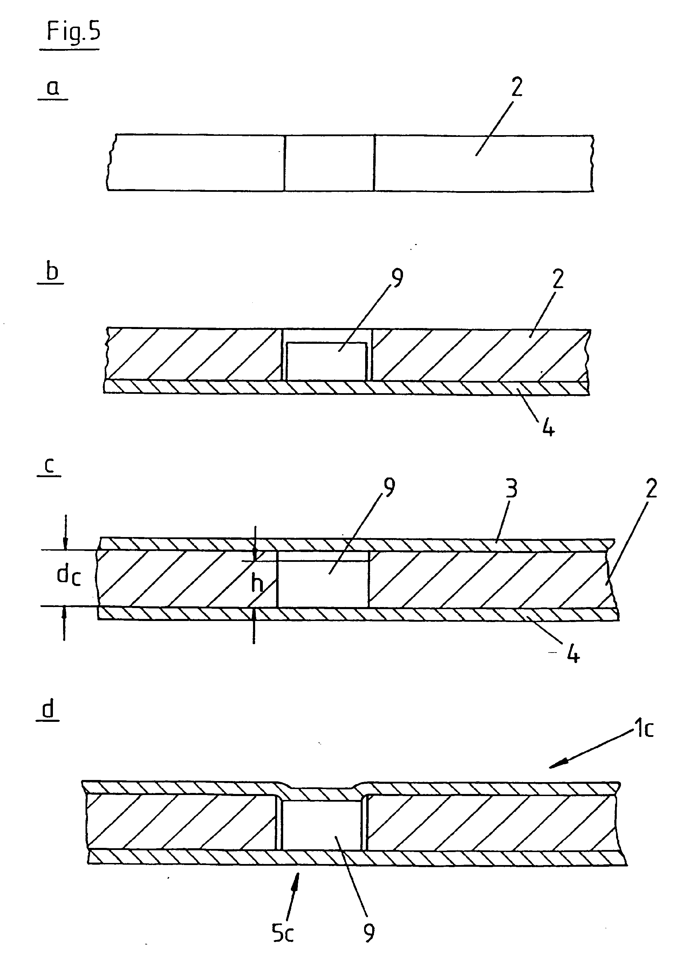

Die Figur 5 zeigt als weitere Möglichkeit ein Verfahren zum Herstellen eines Substrates 1c, wobei dieses Verfahren ähnlich dem Verfahren der Figur 4 ausgebildet ist. Bei diesem Verfahren der Figur 5 wird wiederum beispielsweise zunächst die Metallisierung 4 auf die Unterseite der mit der Öffnung 6 versehenen Schicht aufgebracht. Anschließend wird der Körper 9 in die Öffnung 6 eingesetzt und dann mit Hilfe des DB-Prozesses, d.h. bei Verwendung vom Metallisierungen bzw. Metallfolien aus Kupfer mit Hilfe des DCB-Prozesses die obere Metallisierung 3 sowie gleichzeitig auch die elektrische Verbindung zwischen dem Körper 9 und den beiden Metallisierungen hergestellt, und zwar dadurch, daß nach dem Einbringen des Körpers 9 in die Öffnung 6 auf die Oberseite der Schicht 2 die die Metallisierung 3 bildende Folie aufgelegt wird und die Anordnung dann in einer $N_2/O_2$-Atmosphäre mit einem $O_2$ Gehalt von 5-800ppm auf die DCB-Prozeßtemperatur erhitzt wird.

Die Höhe h des Körpers 9 ist bei dieser Ausführung so gewählt, daß sie nur geringfügig kleiner ist als die Dicke dc der Schicht 2, vorzugsweise ist die Höhe h bei dieser Ausführung so gewählt, daß sie zwar kleiner ist als die Dicke $d_c$ aber zugleich auch gilt:

$$h \leq d_c \left[ (1 + (\alpha_1 - \alpha_2) \Delta T \right] + K$$

Bei diesem Verfahren gemäß Fig. 5 und bei der Einstellung der Höhe h entsprechend den vorgenannten Bedingungen wird erreicht, daß eine Verbindung des Körpers 9 mit den Metallisierungen 3 und 4 mit Hilfe eines Bonding-Prozesses unter Wärmeeinwirkung, beispielsweise mit Hilfe des DCB-Prozesses erreicht wird, ohne daß zuvor mit Hilfe des Werkzeuges oder Stempels 7b ein Verformen einer Metallisierung notwendig ist.

Auch bei dem in den Figuren 4 und 5 dargestellten Verfahren folgt wiederum nur eine einseitige Verformung, d. h. eine Verformung der Metallisierung 3, während die Metallisierung 4 sich hierbei an der Anlage 10 flächig abstützt.

Bei dem vorstehend beschriebenen Verfahren, insbesondere auch bei den Verfahren der Fig. 4 und 5 sind verschiedene Variationen möglich. So ist es beispielsweise möglich, nach dem Einsetzen des Körpers 9 in die Öffnung 6 die Metallisierungen 3 und 4 auf beide Oberflächenseiten der Schicht 2 gleichzeitig aufzubringen.

**Bezugszeichenliste**

| | |
|---|---|
| 1, 1a, 1b, 1c | Substrat |
| 2 | Isolierschicht |
| 3, 4 | Metallisierung |

| 3', 3a', 3b' | Verformter Bereich |
|---|---|
| 5, 5a, 5b, 5c | Durchkontaktierung |
| 6 | Öffnung |
| 7, 7a, 7b | Werkzeug bzw. Stempel |
| 8' | Lötpaste |
| 8 | Lot |
| 9 | Körper aus elektrisch leitendem Material, vorzugsweise Metallkörper |

**Patentansprüche**

1. Verfahren zum Herstellen von Leiterplatten, jeweils bestehend aus wenigstens einer Schicht aus Keramik, die an zwei einander gegenüberliegenden Oberflächenseiten flächig mit wenigstens einer Metallisierung (3) versehen ist, und die wenigstens eine Durchkontaktierung im Bereich einer Öffnung aufweist, wobei das Verfahren folgende Schritte aufweist:

   Aufbringen der Metallisierungen in Form von Metallfolien, beispielsweise Kupferfolien, auf die Oberflächenseiten unter Verwendung der Direct-Copper-Bonding-Technik oder durch Aktivlöten in der Weise, dass die Metallisierungen die Öffnung an der jeweiligen Oberflächenseite der Schicht (2) aus Keramik abdeckt, bleibendes Verformen einer der Metallisierungen (3) in die Öffnung (6) mit Hilfe eines Stempels (7, 7a, 7b), während die andere Metallisierung (4) an einer Auflage (10) abgestützt ist, und zwar in der Weise, dass aus der einen Metallisierung (3) ein in die Öffnung hineinreichender Abschnitt (3', 3a', 3b') geformt ist, und
   Verbinden dieses Abschnitts (3', 3a', 3b') mit der anderen Metallisierung (4) durch Elektroschweißen (Widerstandsschweißen), wobei der Stempel (7, 7a, 7b) zugleich auch als Schweißelektrode verwendet wird.

2. Verfahren zum Herstellen einer Leiterplatte bestehend aus wenigstens einer Schicht (2) aus einem Dielektrikum, vorzugsweise aus Keramik, die an zwei einander gegenüberliegenden Oberflächenseiten flächig mit jeweils wenigstens einer Metallisierung (3) versehen ist und die wenigstens eine Durchkontaktierung im Bereich einer Öffnung (6) aufweist, wobei auf den Oberflächenseiten, vorzugsweise unter Verwendung der Direct-Copper-Bonding-Technik oder durch Aktivlöten, Metallfolien, beispielsweise Kupferfolien aufgebracht werden, die die Metallisierungen bilden und die wenigstens eine Öffnung überdecken, wobei in die Öffnung (6) ein Körper (9) aus elektrisch leitendem Material eingesetzt und mit den Metallisierungen (3,4) unter Anwendung des Direct Bonding Processes beispielsweise des DCB-Prozesses, elektrisch verbunden wird,
   **dadurch gekennzeichnet,**
   **dass** die Höhe (h) des Metallkörpers kleiner ist als die Dicke ($d_c$) der Schicht (2) aus dem Dielektrikum, und dass wenigstens eine Metallisierung (3) derart verformt wird, dass beide Metallisierungen (3, 4) im Bereich der Öffnung (6) gegen den Metallkörper (9) anliegen, und
   **dass** der in die wenigstens eine Öffnung eingesetzte Körper (9) eine Höhe (h) entsprechend den nachstehenden Bedingungen aufweist:

$$h \leq d_c \, [(1 \, + \, (\alpha_1 - \alpha_2) \, \Delta T] \, + \, K,$$

   wobei
   $d_c$ die Dicke der Schicht (2) aus dem Dielektrikum,
   $\alpha_1$ der thermische Ausdehnungskoeffizient des Materials der Schicht (2) aus dem Dielektrikum,
   $\alpha_2$ des thermische Ausdehnungskoeffizient des Materials des eingesetzten Körpers (9),
   $\Delta T$ die Temperaturdifferenz zwischen der beim elektrischen Verbinden verwendeten Prozeßtemperatur und der Raumtemperatur, und
   K ein Korrekturfaktor sind,
   wobei der Korrekturfaktor K der doppelten Schichtstärke der bei diesem Prozess auftretenden Aufschmelzzone entspricht und/oder einen Wert von 5 - 50 $\mu$m hat.

3. Verfahren nach Anspruch 2, **dadurch gekennzeichnet, dass** nur eine der beiden Metallisierungen (3, 4) verformt wird

4. Verfahren nach einem der Ansprüche 1 - 3, **dadurch gekennzeichnet, dass** die eine Metallisierung (3) im Bereich der Öffnung (6) hohlniet- oder tüllen- oder napfartig verformt wird.

5. Leiterplatte, insbesondere für elektrische Schaltungen bestehend aus wenigstens einer Schicht (2) aus Keramik, die an zwei einander gegenüberliegenden Oberflächenseiten flächig mit jeweils wenigstens einer Metallisierung (3) versehen ist und die wenigstens eine Durchkontaktierung im Bereich einer Öffnung (6) aufweist, wobei auf den Oberflächenseiten unter Verwendung der Direct-Copper-Bonding-Technik oder durch Aktivlöten Metallfolien, beispielsweise Kupferfolien, aufgebracht sind, die die Metallisierungen bilden und die wenigstens eine Öffnung überdecken, und wobei die Metalliesierungen durch die Öffnung elektrisch mit einander verbunden sind, **dadurch gekennzeichnet, dass** nur eine der Metallisierungen (3, 4) zur Bildung der Durchkontaktierung (5, 5a, 5b) im Bereich der Öffnung (6) bleibend derart verformt ist, dass sie einen in die Öffnung (6) hineinreichenden Abschnitt (3', 3a', 3b') bildet, und dass dieser Abschnitt im Bereich der Öffnung (6) durch Widerstandsschweißen elektrisch mit der anderen Metallisierung (4) verbunden ist.

6. Leiterplatte, insbesondere für elektrische Schaltungen, bestehend aus wenigstens einer Schicht (2) aus einem Dielektrikum, vorzugsweise aus Keramik, die an zwei einander gegenüberliegenden Oberflächenseiten flächig mit jeweils wenigstens einer Metallisierung (3) versehen ist und die wenigstens eine Durchkontaktierung im Bereich einer Öffnung (6) aufweist, wobei auf den Oberflächenseiten, vorzugsweise unter Verwendung der Direct-Copper-Bonding-Technik oder durch Aktivlöten, Metallfolien, beispielsweise Kupferfolien aufgebracht sind, die die Metallisierungen bilden und die wenigstens eine Öffnung überdecken, wobei in die Öffnung (6) ein Körper (9) aus elektrisch leitendem Material eingesetzt und mit den Metallisierungen (3, 4) unter Anwendung des Direct Bonding Prozesses, beispielsweise des DCB-Prozesses, elektrisch verbunden ist, **dadurch gekennzeichnet, dass** die Höhe (h) des Metallkörpers kleiner ist als die Dicke ($d_c$) der Schicht (2) aus dem Dielektrikum, und dass wenigstens eine Metallisierung (3) derart verformt ist, dass beide Metallisierungen (3, 4) im Bereich der Öffnung (6) gegen den Metallkörper (9) anliegen, wobei vorzugsweise nur eine der beiden Metallisierungen (3, 4) verformt ist, und dass der in die wenigstens eine Öffnung eingesetzte Körper (9) eine Höhe (h) entsprechend den nachstehenden Bedingungen aufweist:

$$h \leq d_c \left[(1 + (\alpha_1 - \alpha_2)\, \Delta T\right] + K,$$

wobei
$d_c$ die Dicke der Schicht (2) aus dem Dielektrikum,
$\alpha_1$ der thermische Ausdehnungskoeffizient des Materials der Schicht (2) aus dem Dielektrikum,
$\alpha_2$ der thermische Ausdehnungskoeffizient des Materials des eingesetzten Körpers (9),
$\Delta T$ die Temperaturdifferenz zwischen der beim elektrischen Verbinden verwendeten Prozeßtemperatur und der Raumtemperatur, und
K ein Korrekturfaktor sind,
wobei der Korrekturfaktor K der doppelten Schichtstärke der bei diesem Prozess auftretenden Aufschmelzzone entspricht und/oder einen Wert von 5 - 50 $\mu$m hat.

7. Leiterplatte nach Anspruch 6, **dadurch gekennzeichnet, dass** nur eine der beiden Metallisierungen (3, 4) verformt ist.

8. Leiterplatte nach einem der Ansprüche 5-7, **dadurch gekennzeichnet, dass** die eine Metallisierung (3) im Bereich der Öffnung (6) hohlniet- oder tüllen- oder napfartig verformt ist.

**Claims**

1. Method for manufacturing printed circuit boards, in each case consisting of at least one layer from ceramic, which is provided 2-dimensionally with at least one metallisation (3) on two opposite-lying surface sides, and which exhibits at least one via in the space of an opening, wherein the method comprises the following steps: applying the metallisations in the form of metal foils, copper foils for example, on the surface sides using direct copper bonding technology or through active soldering in such a way that the opening on the respective surface side of the layer (2) from ceramic covers the metallisations,
permanently crimping one of the metallisations (3) into the opening (6) with the aid of a punch (7, 7a, 7b), while the other metallisation (4) rests on a support (10), and to be precise in such a way that a section (3', 3a', 3b') extending into the opening is formed from the one metallisation (3) and
connecting this section (3', 3a', 3b') to the other metallisation (4) by electric welding (resistance welding), the punch (7, 7a, 7b) at the same time also being used as welding electrode.

**2.** Method for manufacturing a printed circuit board consisting of at least one layer (2) from a dielectric, preferably from ceramic, which is provided 2-dimensionally in each case with at least one metallisation (3) on two opposite-lying surface sides and which comprises at least one via in the space of an opening (6), wherein metal foils, copper foils for example, which form the metallisations and which cover at least one opening, are applied on the surface sides, preferably using direct copper bonding technology or through active soldering, a body (9) from electrically conductive material being inserted into the opening (6) and electrically connected to the metallisations (3, 4) using the direct bonding process, the DCB process for example, **characterized in that** the height (h) of the metal body is less than the thickness ($d_c$) of the layer (2) from the dielectric, and **in that** at least one metallisation (3) is crimped in such a manner that both metallisations (3, 4) lie in the space of the opening (6) against the metal body (9), and
**in that** the body (9) inserted into the at least one opening has a height (h) corresponding to the following requirements:

$$h \leq d_c \ [(1 + (\alpha 1 - \alpha 2) \, \Delta T] + K$$

where
$d_c$ is the thickness of the layer (2) from the dielectric,
$\alpha 1$ is the thermal coefficient of expansion of the material of the layer (2) from the dielectric,
$\alpha 2$ is the thermal coefficient of expansion of the material of the inserted body (9),
$\Delta T$ is the temperature difference between the process temperature, used during the electrical connection, and the ambient temperature and
K is a correction factor,
the correction factor K corresponding to the double layer thickness of the melting zone arising during this process and/or having a value of 5 - 50 $\mu$m.

**3.** Method according to claim 2, **characterized in that** only one of the two metallisations (3, 4) is crimped.

**4.** Method according to anyone of claims 1 - 3, **characterized in that** the one metallisation (3) is crimped hollow rivet- or spout- or cupshape-like in the space of the opening (6).

**5.** Printed circuit board, in particular for electrical circuits consisting of at least one layer (2) from ceramic, which is provided 2-dimensionally in each case with at least one metallisation (3) on two opposite-lying surface sides and which comprises at least one via in the space of an opening (6), wherein metal foils, copper foils for example, which form the metallisations and which cover at least one opening, are applied on the surface sides using direct copper bonding technology or through active soldering, the metallisations being electrically connected to one another through the opening, **characterized in that** only one of the metallisations (3, 4) is permanently crimped in the space of the opening (6) to form the via (5, 5a, 5b) in such a manner that it forms a section (3', 3a', 3b') extending into the opening (6) and that this section is electrically connected to the other metallisation (4) in the space of the opening (6) by resistance welding.

**6.** Printed circuit board, in particular for electrical circuits, consisting of at least one layer (2) from a dielectric, preferably from ceramic, which is provided 2-dimensionally in each case with at least one metallisation (3) on two opposite-lying surface sides and which comprises at least one via in the space of an opening (6), wherein metal foils, copper foils for example, which form the metallisations and which cover at least one opening, are applied on the surface sides, preferably using direct copper bonding technology or through active soldering, a body (9) from electrically conductive material being inserted into the opening (6) and electrically connected to the metallisations (3, 4) using the direct bonding process, the DCB process for example, **characterized in that** the height (h) of the metal body is less than the thickness ($d_c$) of the layer (2) from the dielectric, and **in that** at least one metallisation (3) is crimped in such a manner that both metallisations (3, 4) lie in the space of the opening (6) against the metal body (9), preferably only one of the two metallisations (3, 4) being crimped, and
**in that** the body (9) inserted into the at least one opening has a height (h) corresponding to the following requirements:

$$h \leq d_c \ [(1 + (\alpha 1 - \alpha 2) \, \Delta T] + K$$

where

$d_c$ is the thickness of the layer (2) from the dielectric,

$\alpha 1$ is the thermal coefficient of expansion of the material of the layer (2) from the dielectric,

$\alpha 2$ is the thermal coefficient of expansion of the material of the inserted body (9),

$\Delta T$ is the temperature difference between the process temperature, used during the electrical connection, and the ambient temperature and

K is a correction factor,

the correction factor K corresponding to the double layer thickness of the melting zone arising during this process and/or having a value of 5 - 50 $\mu$m.

7. Printed circuit board according to claim 6, **characterized in that** only one of the two metallisations (3, 4) is crimped.

8. Printed circuit board according to anyone of claims 5-7, **characterized in that** the one metallisation (3) is crimped hollow rivet- or spout- or cupshape-like in the space of the opening (6).


**Revendications**

1. Procédé de fabrication de circuit imprimé, constitué respectivement d'au moins une couche de céramique, qui est munie en surface, sur deux côtés superficiels se faisant mutuellement face, d'au moins une métallisation (3) et qui présente dans la zone d'une ouverture au moins une connexion traversante, le procédé comportant les étapes suivantes consistant à : appliquer les métallisations sous la forme de feuilles métalliques, par exemple des feuilles de cuivre, sur les faces superficielles en utilisant le procédé de cuivre à liaison directe ou par soudage actif de telle manière que les métallisations recouvrent l'ouverture au niveau des faces superficielles respectives de la couche (2) en céramique,

de manière complémentaire une des métallisations (3) dans l'ouverture (6) à l'aide d'un poinçon (7, 7a, 7b), tandis que l'autre métallisation (4) est soutenue sur un support (10), et cela de telle manière qu'une section (3', 3a', 3b') pénétrant dans l'ouverture est formée à partir d'une métallisation (3), et

lier cette section (3', 3a', 3b') avec l'autre métallisation (4) par électrosoudage (soudage par résistance), le poinçon (7, 7a, 7b) étant simultanément utilisé aussi comme électrode de soudage.

2. Procédé de fabrication d'un circuit imprimé constitué d'au moins une couche (2) en un diélectrique, de préférence en céramique, qui est munie en surface, sur deux faces superficielles se faisant face, de respectivement au moins une métallisation (3) et qui présente au moins une connexion traversante dans la zone d'une ouverture (6), des feuilles métalliques, par exemple des feuilles de cuivre, qui forment les métallisations et recouvrent la au moins une ouverture,

étant appliquées sur les faces superficielles, de préférence en utilisant le procédé de cuivre à liaison directe ou par soudage actif,

un corps (9) en matériau électriquement conducteur étant inséré dans l'ouverture (6) et relié électriquement avec les métallisations (3, 4) en utilisant le procédé de cuivre à liaison directe, par exemple le procédé de cuivre à liaison directe,

**caractérisé en ce que**

la hauteur (h) du corps métallique est inférieure à l'épaisseur ($d_c$) de la couche (2) en diélectrique, et

au moins une métallisation (3) est mise en forme de sorte que les deux métallisations (3, 4) se situent contre le corps métallique (9), dans la zone de l'ouverture (6), et

le corps (9) inséré dans la au moins une ouverture présente une hauteur (h) correspondant aux conditions ci-dessous :

$$h \leq d_c[(1 + (\alpha_1 - \alpha_2)\Delta T] + K,$$

dans lesquelles

de est l'épaisseur de la couche (2) en diélectrique,

$\alpha_1$ est le coefficient de dilatation thermique du matériau de la couche (2) en diélectrique,

$\alpha_2$ est le coefficient de dilatation thermique du matériau du corps (9) inséré,

$\Delta T$ est la différence de température entre la température de procédé utilisée pour la liaison électrique et la température ambiante, et

K est un facteur de correction,
le facteur de correction K correspondant à la double intensité de couche de la zone de surfusion apparaissant dans ce procédé et/ou ayant une valeur de 5 à 50 $\mu$m.

**3.** Procédé selon la revendication 2, **caractérisé en ce que** seulement une des deux métallisations (3, 4) est mise en forme.

**4.** Procédé selon l'une quelconque des revendications 1 à 3, **caractérisé en ce qu'**une forme de rivet creux ou de douille ou de bol est donnée à la métallisation (3) dans la zone d'ouverture (6).

**5.** Circuit imprimé, en particulier pour des commutations électriques, constitué d'au moins une couche (2) en céramique, qui est munie en surface, sur deux faces superficielles se faisant mutuellement face, d'au moins une métallisation (3) et qui présente dans la zone d'une ouverture (6) au moins une connexion traversante, des feuilles métalliques, par exemple des feuilles de cuivre, qui forment les métallisations et recouvrent la au moins une ouverture, étant appliquées sur les faces superficielles en utilisant le procédé de cuivre à liaison directe ou par soudage actif, et les métallisations étant reliées électriquement l'une à l'autre à travers l'ouverture, **caractérisé en ce que**
une des métallisations (3, 4) seulement est mise en forme de manière complémentaire pour former la connexion traversante (5, 5a, 5b) dans la zone de l'ouverture (6) de telle sorte qu'elle forme une section (3', 3a', 3b') pénétrant dans l'ouverture (6), et
cette section est reliée électriquement avec l'autre métallisation (4) dans la zone de l'ouverture (6) par soudage par résistance.

**6.** Circuit imprimé, en particulier pour des commutations électriques, constitué d'au moins une couche (2) en un diélectrique, de préférence en céramique, qui est munie en surface, sur deux faces superficielles se faisant face, de respectivement au moins une métallisation (3) et qui présente au moins une connexion traversante dans la zone d'une ouverture (6), des feuilles métalliques, par exemple des feuilles de cuivre, qui forment les métallisations et recouvrent la au moins une ouverture,
étant appliquées sur les faces superficielles, de préférence en utilisant le procédé de cuivre à liaison directe ou par soudage actif,
un corps (9) en matériau électriquement conducteur étant inséré dans l'ouverture (6) et relié électriquement avec les métallisations (3, 4) en utilisant le procédé de cuivre à liaison directe, par exemple le procédé de cuivre à liaison directe,
**caractérisé en ce que**
la hauteur (h) du corps métallique est inférieure à l'épaisseur ($d_c$) de la couche (2) en diélectrique, et
au moins une métallisation (3) est mise en forme de sorte que les deux métallisations (3, 4) se situent contre le corps métallique (9), dans la zone de l'ouverture (6),
une des deux métallisations (3, 4) seulement étant de préférence mise en forme, et
le corps (9) inséré dans la au moins une ouverture présente une hauteur (h) correspondant aux conditions ci-dessous :

$$h \leq d_c[(1 + (\alpha_1 - \alpha_2)\Delta T] + K,$$

dans lesquelles
$d_c$ est l'épaisseur de la couche (2) en diélectrique,
$\alpha_1$ est le coefficient de dilatation thermique du matériau de la couche (2) en diélectrique,
$\alpha_2$ est le coefficient de dilatation thermique du matériau du corps (9) inséré,
$\Delta T$ est la différence de température entre la température de procédé utilisée pour la liaison électrique et la température ambiante, et
K est un facteur de correction,
le facteur de correction K correspondant à la double intensité de couche de la zone de surfusion apparaissant dans ce processus et/ou ayant une valeur de 5 à 50 nm.

**7.** Circuit imprimé selon la revendication 6, **caractérisé en ce que** une des deux métallisations (3, 4) seulement est mise en forme.

**8.** Circuit imprimé selon l'une quelconque des revendications 5 à 7, **caractérisé en ce qu'**une forme de rivet creux ou de douille ou de bol est donnée à la métallisation (3) dans la zone de l'ouverture (6).

Fig.1

a

6

2

b

6

3

4

c

6

7

1

$d_c$

$d_{cu}$

10

3'

5

3'

## Fig.2

<u>a</u>

<u>b</u>

## Fig.3

Fig.4

<u>a</u>

<u>b</u>

<u>c</u>

<u>d</u>

## Fig.5

### a

### b

### c

### d

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US PS3744120 A
- DE PS2319854 C
- DE 2213115
- US 4319708 A
- DE 1920061 U
- EP 0627875 A